## Europäisches Patentamt
## European Patent Office
## Office européen des brevets

(19)

(11) Veröffentlichungsnummer: **0 004 900**
A2

(12) # EUROPÄISCHE PATENTANMELDUNG

(21) Anmeldenummer: **79101010.1**

(22) Anmeldetag: **03.04.79**

(51) Int. Cl.²: **G 02 B 5/30**
**C 23 C 13/06**

(30) Priorität: **25.04.78 DE 2818103**

(43) Veröffentlichungstag der Anmeldung:
**31.10.79 Patentblatt 79/22**

(84) Benannte Vertragsstaaten:
**CH FR GB IT NL SE**

(71) Anmelder: SIEMENS AKTIENGESELLSCHAFT Berlin
und München
Postfach 261
D-8000 München 22(DE)

(72) Erfinder: Krüger, Hans, Dipl.-Ing.
Peralohstrasse 13
D-8000 München 83(DE)

(72) Erfinder: Rehme, Hans, Dr.
Herzog-Albrecht-Strasse 13
D-8011 Zorneding(DE)

(54) **Verfahren zur Herstellung von aus einer Vielzahl von auf einer Glasträgerplatte angeordneten parallel zueinander ausgerichteten elektrisch leitenden Streifen bestehenden Polarisatoren.**

(57) Die Erfindung betrifft ein Verfahren zur Herstellung von aus einer Vielzahl von auf einer Glasträgerplatte angeordneten parallel zueinander ausgerichteten elektrisch leitenden Streifen bestehenden Polarisatoren mit einem Rastermaß von ca. 1/10 der Lichtwellenlänge. Das Verfahren ist dadurch gekennzeichnet, daß ein erster Verfahrensschritt vorgesehen ist, bei dem auf die Glasträgerplatte durch Bedampfen unter einem vorgegebenen Bedampfungswinkel eine wellige, dünenartige Schicht aus leitfähigem Material mit senkrecht zur Bedampfungsrichtung ausgerichteter gleichmäßiger Oberflächenwelligkeit mit einer Pierode von ca. 50 nm aufgebracht wird, und daß ein zweiter Verfahrensschritt vorgesehen ist, bei dem eine vorgegebene Stärke der dünenartigen Schicht durch Teilchenbeschuß unter einem vorgegebenen Beschußwinkel abgetragen wird, so daß eine Anordnung einer Vielzahl von parallel zueinander ausgerichteter, voneinander getrennter und damit elektrisch gegeneinander isolierter Mikrostreifen auf der Glasträgerplatte entsteht.

FIG 6

EP 0 004 900 A2

SIEMENS AKTIENGESELLSCHAFT
Berlin und München

Unser Zeichen
VPA 78 P 7 0 4 2

Verfahren zur Herstellung von aus einer Vielzahl von auf einer Glasträgerplatte angeordneten parallel zueinander ausgerichteten elektrisch leitenden Streifen bestehenden Polarisatoren.

Die Erfindung betrifft ein Verfahren zur Herstellung von aus einer Vielzahl von auf einer Glasträgerplatte angeordneten parallel zueinander ausgerichteten elektrisch leitenden Streifen bestehenden Polarisatoren mit einem Rastermaß von ca. 1/10 der Lichtwellenlänge.

Der Erfindung liegt die Aufgabe zugrunde, ein kostengünstiges und leicht reproduzierbares Verfahren anzugeben, mit dessen Hilfe Polarisationsfilter der angegebenen Art herzustellen sind. Dabei liegt die Erkenntnis zugrunde, daß die für Zwecke der Lichtpolarisation nötigen Abstände und Breiten von parallel zueinander verlaufenden elektrisch leitenden, durch an sich bekanntes Auftragen bzw. Abtragen von Metallschichten auf Glasträgerplatten durch Schrägbedampfen bzw. Schrägbeschuß erhaltbar sind.

Pap 1 Plr / 25.4.1978

Die genannte Aufgabe wird durch ein eingangs erwähntes Verfahren gelöst, das dadurch gekennzeichnet ist, daß ein erster Verfahrensschritt vorgesehen ist, bei dem auf eine Glasträgerplatte durch Bedampfen unter einem vorgegebenen Bedampfungswinkel eine wellige, dünenartige Schicht aus leitfähigem Material mit senkrecht zur Bedampfungsrichtung ausgerichteter gleichmäßiger Oberflächenwelligkeit mit einer Periode von ca. 50 nm aufgebracht wird und daß ein zweiter Verfahrensschritt vorgesehen ist, bei dem eine vorgegebene Stärke der dünenartigen Schicht durch Teilchenbeschuß unter einem vorgegebenen Beschußwinkel abgetragen wird, so daß eine Anordnung einer Vielzahl von parallel zueinander ausgerichteter, voneinander getrennter und damit elektrisch gegeneinander isolierter Mikrostreifen auf der Glasträgerplatte entsteht.

Die Erfindung bietet den Vorteil, daß ein kostengünstiges und leicht reproduzierbares Herstellungsverfahren für Polarisatoren gegeben ist und daß die Lebensdauer von nach dem erfindungsgemäßen Verfahren hergestellten Polarisatoren gegenüber herkömmlichen Polarisatoren erhöht ist.

Eine Weiterbildung der Erfindung ist dadurch gekennzeichnet, daß ein erster Verfahrensschritt vorgesehen ist, bei dem zur Ausbildung einer einheitlichen periodischen Oberflächenstruktur auf der Glasträgerplatte ein solcher Auftreffwinkel von Teilchen eingestellt ist, daß sich eine Periode >50 nm <5000 nm ergibt, und daß ein zweiter Verfahrensschritt vorgesehen ist, bei dem mittels einer Bedampfungsquelle, die senkrecht zur Längsausdehnung der im ersten Verfahrensschritt erzeugten Mikrorillen orientiert ist, eine Bedampfung mit elektrisch leitendem Material unter einem vorgegebenen streifenden Bedampfungsauftreffwinkel durchgeführt wird, so daß jeweils nur auf den der Bedampfungsquelle zugewandten Innenflächen der betreffenden Mikrorillen Material abgelagert wird, wodurch eine vorgegebene Anordnung von Mikrostreifen auf
der Glasträgerplatte entsteht, die insgesamt eine Flüssigkristallmoleküle mit definiertem Anstellwinkel orientierende Oberflächenstruktur aufweist.

Die Weiterbildung der Erfindung bietet den Vorteil, daß
mit einer geringen Anzahl von Verfahrensschritten Polarisatoren herstellbar sind, denen eine Oberflächenstruktur
der Glasträgerplatte unterlagert ist, die das für Flüssigkristallanzeigen erforderliche Orientieren der Flüssigkristallmoleküle erlaubt, so daß insgesamt Flüssigkristallanzeigen mit optimalen Eigenschaften herstellbar sind.

Die Erfindung wird im folgenden anhand mehrerer, Ausführungsbeispiele für die Erfindung betreffender Figuren
erläutert.

Fig. 1 zeigt schematisch in Draufsicht einen Polarisator 1, der aus einer Glasträgerplatte und auf
dieser in der gezeigten Weise angeordneten
Mikrostreifen 2 besteht.

Fig. 2 zeigt ausschnittsweise im Querschnitt eine Glasträgerplatte 3 und eine auf diese durch Schrägbedampfung aufgebrachte, wellige, dünenartige
Schicht 4.

Fig. 3 zeigt ebenfalls ausschnittsweise im Querschnitt
eine Glasträgerplatte 3 mit einer auf diese aufgebrachte ebenen Schicht 5.

Fig. 4 zeigt wiederum ausschnittsweise den Querschnitt
einer Glasträgerplatte 3, auf der durch die erfindungsgemäßen Verfahrensschritte erzielbare
Mikrostreifen 2, die voneinander getrennt und damit elektrisch gegeneinander isoliert sind, lagern.

Fig. 5 zeigt ausschnittsweise den Querschnitt einer Glasträgerplatte 3, die gemäß einem erfindungsgemäßen Verfahrensschritt mit Teilchen 6 unter einem Beschußauftreffwinkel $\varphi$ beschossen wird.

Fig. 6 zeigt ausschnittsweise den Querschnitt einer Glasträgerplatte 3, in deren Oberfläche nach einem Teilchenbeschuß gemäß Fig. 5 eine Vielzahl von parallel zueinander angeordneten Mikrorillen eingeprägt ist, deren einer Bedampfungsquelle zugewandten Innenflächen durch unter einem Bedampfungsauftreffwinkel $\beta$ auftreffendes Material 7 mit einer elektrisch leitenden Oberfläche versehen werden, so daß eine Vielzahl von parallel zueinander ausgerichteten, voneinander getrennten und damit elektrisch gegeneinander isolierten Mikrostreifen 2 entsteht.

Fig. 7 zeigt im Querschnitt eine Glasträgerplatte 3, deren Oberfläche in einem ersten Verfahrensschritt mit Teilchen 6 unter einem ersten Auftreffwinkel $\varphi_1$ innerhalb eines ersten Winkelbereiches $\emptyset_1$ und in einem zweiten Verfahrensschritt mit Teilchen 6 unter einem zweiten Auftreffwinkel $\varphi_2$ innerhalb eines zweiten Winkelbereiches $\emptyset_2$ beschossen wird.

Fig. 8 zeigt in perspektivischer Darstellung eine Glasträgerplatte 3, deren Oberfläche mit Teilchen unter einem ersten Auftreffwinkel $\varphi_1$ beschossen wird, so daß eine erste Oberflächenstruktur 8 entsteht.

Fig. 9 zeigt ebenfalls in perspektivischer Ansicht die Glasträgerplatte 3, deren Oberfläche mit Teilchen unter einem zweiten Auftreffwinkel $\varphi_2$ beschossen

wird, wobei eine zweite Oberflächenstruktur 9 entsteht.

Fig. 10 zeigt eine Glasträgerplatte 3, auf deren Oberfläche in der Bearbeitungsebene A-B-C-D eine Rillenstruktur erzeugt wird, indem in einem ersten Arbeitsgang durch Teilchenbeschuß unter dem Auftreffwinkel $\varphi$1 eine Rillenstruktur 1 gemäß Fig. 8 und in einem zweiten Arbeitsgang durch Teilchenbeschuß unter dem Auftreffwinkel $\varphi$2 eine zur Rillenstruktur 1 parallele Rillenstruktur 2 gemäß Fig. 9 hergestellt wird.

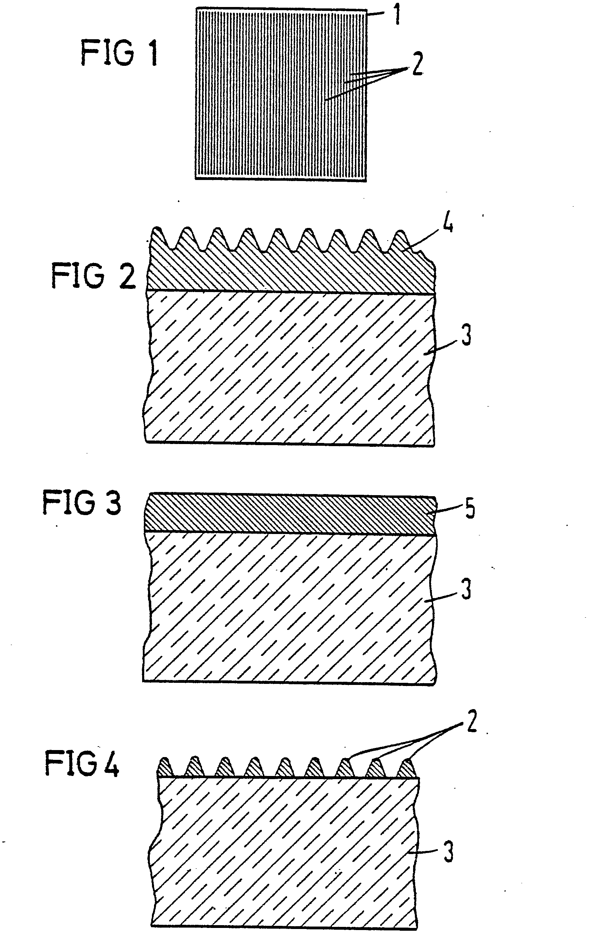

Wie bereits erläutert, zeigt Figur 1 schematisch in Draufsicht einen Polarisator 1, der aus einer Glasträgerplatte und auf dieser in der gezeigten Weise angeordneten Mikrostreifen 2 besteht. Die Wirkung eines solchen Polarisators beruht bekanntlich darauf, daß das sich ergebende Abstands-/Breitenraster der Anordnung von Mikrostreifen der mittleren Wellenlänge sichtbaren Lichtes angepaßt ist.

Figur 2 zeigt, wie ebenfalls bereits erläutert, ausschnittsweise im Querschnitt eine Glasträgerplatte 3 und eine auf diese durch Schrägbedampfung aufgebrachte wellige, dünenartige Schicht 4. Die Ausbildung einer solchen welligen Oberfläche ist bei Bedampfung unter einem bestimmten Bedampfungswinkel erreichbar. Es ist nun eine Eigenart einer solchen Bedampfungsmethode, daß bei geeignetem Bedampfungswinkel die Welligkeit der Oberfläche eine Periode von ca. 500Å aufweist, die gut an die Funktion eines damit realisierten Polarisators für sichtbares Licht angepaßt ist. Aus der dünenartigen Schicht 4 ist nun gemäß Figur 4 eine Anordnung von parallel zueinander ausgerichteten Mikrostreifen 2 dadurch zu gewinnen, daß in einem weiteren Verfahrens-

schritt ein Teilchenbeschuß unter einem vorgegebenen Beschußwinkel vorgenommen wird, mittels dessen ein Abtragen von Material erfolgt. Das Abtragen von Material mittels Teilchenbeschuß ist an sich bekannt.

Figur 3 zeigt, wie bereits erläutert, ebenfalls ausschnittsweise im Querschnitt eine Glasträgerplatte 3, mit einer auf diese aufgebrachten ebenen Schicht 5. Eine solche ebene Schicht entsteht gemäß einer Weiterbildung der Erfindung dadurch, daß die Bedampfung der Glasträgerplatte 3 unter einem vorzugsweise 90° betragenden Bedampfungswinkel vorgenommen wird. Zum Erzeugen einer welligen Oberflächenstruktur ist in diesem Ausführungsbeispiel ein Teilchenbeschuß unter einem vorgegebenen Auftreffwinkel vorgesehen, durch den Mikrorillen in die ebene Schicht 5 eingeprägt werden. Die endgültige Oberflächenstruktur gemäß Figur 4 wird nach dieser Weiterbildung der Erfindung dadurch erreicht, daß anstelle des zweiten Verfahrensschrittes ein Verfahrensschritt vorgesehen ist, bei dem durch Materialabtrag mittels unter einem Winkel zur Bearbeitungsebene ausgerichteten Teilchenbeschusses eine Welligkeit der ursprünglich ebenen Schicht 5 entsteht, so daß eine vorgegebene Anordnung von Mikrostreifen 2 auf der Glasträgerplatte 3 entsteht.

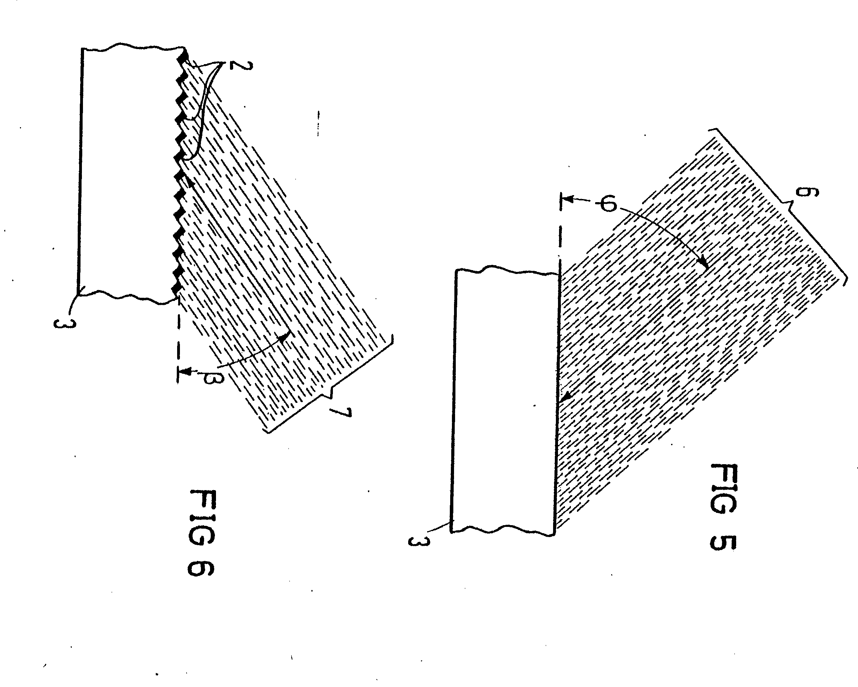

Wie bereits erläutert, zeigt Figur 5 ausschnittsweise den Querschnitt einer Glasträgerplatte 3, die gemäß einem erfindungsgemäßen Verfahrensschritt mit Teilchen 6 unter einem Beschußauftreffwinkel $\varphi$ beschossen wird. Durch diesen Teilchenbeschuß entsteht ein je nach Wahl des Beschußauftreffwinkels $\varphi$ parallel oder quer zur Beschußrichtung orientiertes Mikrorillenmuster, das in einem zweiten Verfahrensschritt gemäß Figur 6 durch Bedampfen senkrecht zur Längsausdehnung der Mikrorillen unter einem vorgegebenen Bedampfungsauftreffwinkel $\beta$ durchgeführt wird, so daß jeweils nur auf den der Bedampfungsquelle zugewandten Innenflächen der Mikrorillen Material abgelagert wird, wodurch eine vorgegebene Anordnung von Mikrostreifen 2 auf der Glasträgerplatte 3 entsteht.

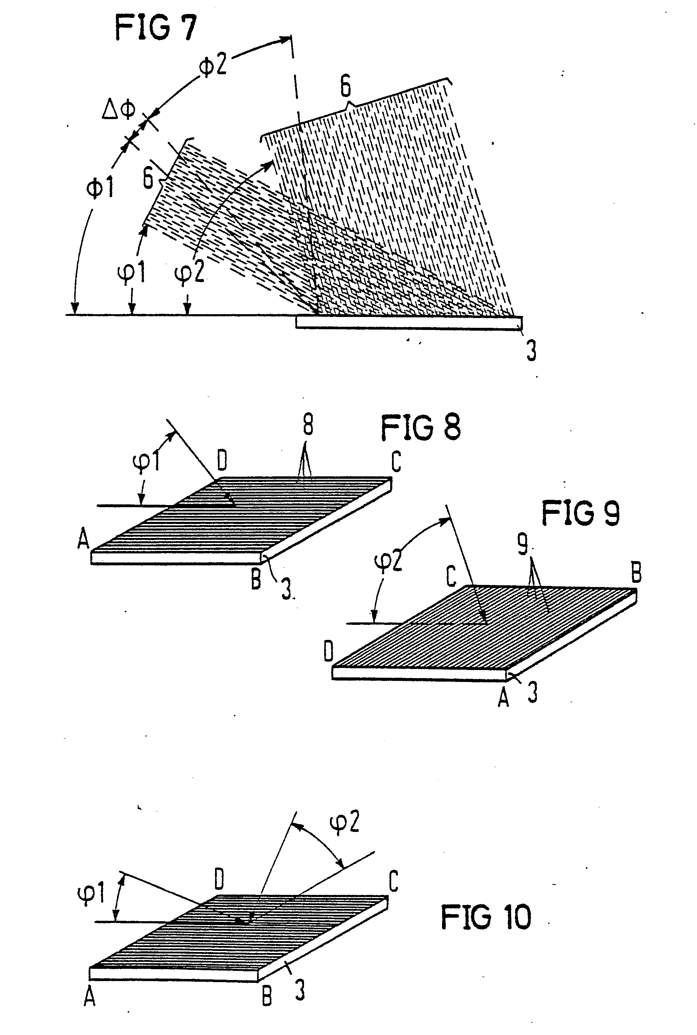

Figur 7 zeigt, wie bereits erläutert, im Querschnitt eine Glasträgerplatte 3, deren Oberfläche in einem ersten Verfahrensschritt mit Teilchen 6 unter einem ersten Auftreffwinkel $\varphi 1$ innerhalb eines ersten Winkelbereiches $\emptyset 1$ und in einem zweiten Verfahrensschritt mit Teilchen 6 unter einem zweiten Auftreffwinkel $\varphi 2$ innerhalb eines zweiten Winkelbereiches $\emptyset 2$ beschossen wird. Die sich jeweils aus dem Teilchenbeschuß unter dem ersten Auftreffwinkel $\varphi 1$ bzw. dem zweiten Auftreffwinkel $\varphi 2$ ergebenden Oberflächenstrukturen 8 und 9 sind aus den Figuren 8 und 9 ersichtlich. Im ersteren Fall verlaufen die entstandenen Mikrorillen in Richtung des Teilchenbeschusses, im zweiten Fall verlaufen die entstandenen Mikrorillen senkrecht zur Beschußrichtung, vergl. Figuren 8 und 9. Die beiden Oberflächenstrukturen 8 und 9 überlagern sich, d. h., die eine Struktur moduliert die andere. Wird die derart strukturierte Glasträgerplatte in einem dritten Verfahrensschritt mittels einer Bedampfungsquelle, die senkrecht zur Längsausdehnung der im ersten oder im zweiten Verfahrensschritt erzeugten Mikrorillen orientiert ist bedampft, so entsteht eine Ablagerung von Material auf den der Bedampfungsquelle zugewandten Innenflächen der Mikrorillen, wodurch insgesamt eine Anordnung von Mikrostreifen 2 auf der Glasträgerplatte 3 entsteht, die außerdem eine Flüssigkristallmoleküle orientierende Funktion aufweist.

Zur Erzielung besonderer Eigenschaften, nämlich zur Ausbildung eines optimalen Wertes für die Rillengeometrie und eines optimalen Wertes für den Anstellwinkel $\Theta$ wird vorteilhafterweise die Glasträgerplatte 3 zur Durchführung des zweiten Teilchenbeschusses gemäß Fig. 7 bzw.

Fig. 9 die Bearbeitungsebene A-B-C-D der Glasträgerplatte um eine senkrecht auf ihr stehende Achse gedreht. Der Drehungswinkel beträgt dabei zweckmäßig 90°. Der zweite Auftreffwinkel $\varphi 2$ kann zur Erzielung eines besonderes vorgegebenen Verhältnisses der Rillengeometrie zum Anstellwinkel $\Theta$ 90° betragen.

Prinzipiell ist die Reihenfolge des Teilchenbeschusses unter dem ersten Auftreffwinkel $\varphi 1$ bzw. dem zweiten Auftreffwinkel $\varphi 2$ vertauschbar. Die Oberflächenstrukturierung der Glasträgerplatte 3 kann je nach Verwendungszweck des fertigen Produktes parallel und/oder senkrecht zu den Kanten A-B, B-C, C-D, D-A der Bearbeitungsebene A-B-C-D oder schräg zu diesen Kanten vorgenommen werden.

Für den Teilchenbeschuß können elektrisch neutrale Teilchen oder beispielsweise Ionen vorgesehen sein. Für den Fall, daß Ionen verwendet werden, ist vorgesehen, gegebenenfalls auftretende störende elektrische Aufladungen der bearbeiteten Glasträgerplatte ohne einen zusätzlichen Verfahrensschritt durch an sich bekannte Maßnahmen zu neutralisieren.

Statt eines Bedampfens kann ein Auftragen von Material mittels Sputtern vorgesehen sein. Es ist außerdem in einer Weiterbildung der Erfindung vorgesehen, daß anstelle des Bedampfens ein Auftragen von Material mittels selektiver chemischer Abscheidung nach an sich bekannten Verfahren vorzunehmen ist.

Die polarisierende Schicht, die durch die Anordnung parallel zueinander orientierter Mikrostreifen gegeben ist, ist bei Anordnung über einer Flüssigkristallanzeige-Einrichtung zur Verhütung störender elektrisch leitender Verbindungen durch eine Isolierschicht, beispielsweise aus Quarz oder ähnlichen geeigneten Schichten

zu trennen.

Der Anstellwinkel der Orientierung ist auch vorteilhafterweise durch einen dritten Verfahrensschritt, nämlich durch schräges Aufdampfen oder schräges Abtragen mittels Teilchenbeschuß oder schräges Überreiben einstellbar.


18 Patentansprüche
10 Figuren

Patentansprüche.

1. Verfahren zur Herstellung von aus einer Vielzahl von auf einer Glasträgerplatte angeordneten parallel zueinander ausgerichteten elektrisch leitenden Streifen* mit einem Rastermaß von ca. 1/10 der Lichtwellenlänge, d a d u r c h g e k e n n z e i c h n e t , daß ein erster Verfahrensschritt vorgesehen ist, bei dem auf die Glasträgerplatte (3) durch Bedampfen unter einem vorgegebenen Bedampfungswinkel eine wellige, dünenartige Schicht (4) aus leitfähigem Material mit senkrecht zur Bedampfungsrichtung ausgerichteter gleichmäßiger Oberflächenwelligkeit mit einer Periode von ca. 50 nm aufgebracht wird, und daß ein zweiter Verfahrensschritt vorgesehen ist, bei dem eine vorgegebene Stärke der dünenartigen Schicht (4) durch Teilchenbeschuß unter einem vorgegebenen Beschußwinkel abgetragen wird, so daß eine Anordnung einer Vielzahl von parallel zueinander ausgerichteter, voneinander getrennter und damit elektrisch gegeneinander isolierender Mikrostreifen (2) auf der Glasträgerplatte (3) entsteht.          * bestehenden Polarisatoren

2. Verfahren nach Anspruch 1, d a d u r c h g e - k e n n z e i c h n e t , daß für den ersten Verfahrensschritt ein Bedampfungswinkel vorgesehen ist, unter dem eine elektrisch leitende ebene Schicht (5) auf der Glasträgerplatte (3) entsteht, und daß anstelle des zweiten Verfahrensschrittes ein Verfahrensschritt vorgesehen ist, bei dem durch Materialabtrag mittels unter einem Winkel zur Bearbeitungsebene ausgerichteten Teilchenbeschusses eine Welligkeit der ursprünglich ebenen Schicht (5) entsteht, so daß eine vorgegebene Anordnung von Mikrostreifen (2) auf der Glasträgerplatte (3) entsteht.

3. Verfahren nach Anspruch 1, d a d u r c h g e - k e n n z e i c h n e t , daß ein erster Verfahrens-

schritt vorgesehen ist, bei dem in die Oberfläche der Glasträgerplatte (3) durch Teilchenbeschuß unter einem vorgegebenen Beschußauftreffwinkel ($\varphi$) mittels Teilchen (6) ein Mikrorillenmuster eingeprägt wird, und daß ein Bedampfen während eines zweiten Verfahrensschrittes senkrecht zur Längsausdehnung der Mikrorillen und unter einem vorgegebenen Bedampfungsauftreffwinkel ($\beta$) durchgeführt wird, so daß jeweils nur auf den der Bedampfungsquelle zugewandten Innenfläche der Mikrorillen Material abgelagert wird, wodurch eine vorgegebene Anordnung von Mikrostreifen (2) auf der Glasträgerplatte (3) entsteht.

4. Verfahren nach Anspruch 3, d a d u r c h   g e - k e n n z e i c h n e t ,  daß ein erster Verfahrensschritt vorgesehen ist, bei dem zur Ausbildung einer einheitlichen periodischen Oberflächenstruktur auf der Glasträgerplatte (3) ein solcher Auftreffwinkel ($\varphi$1) von Teilchen (6) eingestellt ist, daß sich eine Periode >50 nm < 5000 nm ergibt, und daß ein zweiter Verfahrensschritt vorgesehen ist, bei dem mittels einer Bedampfungsquelle, die senkrecht zur Längsausdehnung der im ersten Verfahrensschritt erzeugten Mikrorillen orientiert ist, eine Bedampfung mit elektrisch leitendem Material unter einem vorgegebenen streifenden Bedampfungsauftreffwinkel ($\beta$) durchgeführt wird, so daß jeweils nur auf den der Bedampfungsquelle zugewandten Innenflächen der betreffenden Mikrorillen Material abgelagert wird, wodurch eine vorgegebene Anordnung von Mikrostreifen (2) auf der Glasträgerplatte (3) entsteht, die insgesamt eine Flüssigkristallmoleküle mit definiertem Anstellwinkel orientierende Oberflächenstruktur aufweist.

5. Verfahren nach Anspruch 4, d a d u r c h   g e - k e n n z e i c h n e t ,  daß die zu bearbeitende, Glasträgerplatte (3) zur Durchführung des zweiten Verfahrensschrittes um eine senkrecht auf ihrer Bearbeitungsebene (A-B-C-D) stehende Achse gedreht wird.

6. Verfahren nach Anspruch 5, d a d u r c h   g e -
k e n n z e i c h n e t , daß die Glasträgerplatte
(3) um 90° gedreht wird.

7. Verfahren nach Anspruch 4, d a d u r c h   g e -
k e n n z e i c h n e t , daß die Teilchenkanone zur
Durchführung des zweiten Verfahrensschrittes um eine
senkrecht auf der Bearbeitungsebene (A-B-C-D) der Glasträgerplatte (3) stehende Achse geschwenkt wird.

8. Verfahren nach Anspruch 4, d a d u r c h   g e -
k e n n z e i c h n e t , daß zur Durchführung des ersten Verfahrensschrittes eine erste Teilchenkanone vorgesehen ist, daß zur Durchführung des zweiten Verfahrensschrittes eine zweite Teilchenkanone vorgesehen ist und
daß die zweite Teilchenkanone gegenüber der ersten Teilchenkanone um eine senkrecht auf der Bearbeitungsebene
(A-B-C-D) der Glasträgerplatte (3) stehende Achse versetzt angeordnet ist.

9. Verfahren nach den Ansprüchen 4 bis 6, d a d u r c h
g e k e n n z e i c h n e t , daß zur Erzeugung eines
Parallelrillenmusters mit um einen vorgegebenen Anstellwinkel (Θ) gegenüber der Bearbeitungsebene (A-B-C-D) geneigter Orientierung der Flüssigkristallmoleküle und mit
einer vorgegebenen Rillentiefe (T), bei dem der erste
Auftreffwinkel ($\psi$1) und der zweite Auftreffwinkel ($\psi$2)
in einem vorgegebenen Verhältnis zueinander eingestellt
sind.

10. Verfahren nach Anspruch 9, d a d u r c h   g e -
k e n n z e i c h n e t , daß der zweite Auftreffwinkel
($\psi$2) 90° beträgt.

11. Verfahren nach einem der Ansprüche 4 bis 10, d a - d u r c h   g e k e n n z e i c h n e t ,  daß die Reihenfolge des ersten Verfahrensschrittes mit dem zweiten Verfahrensschritt vertauscht ist.

12. Verfahren nach einem der Ansprüche 4 bis 11, d a - d u r c h   g e k e n n z e i c h n e t ,  daß die Oberflächenstrukturierung der Glasträgerplatte (3) parallel und/oder senkrecht zu den Kanten (A-B, B-C, C-D, D-A) der Bearbeitungsebene (A-B-C-D) vorzunehmen ist.

13. Verfahren nach einem der Ansprüche 4 bis 11, d a - d u r c h   g e k e n n z e i c h n e t ,  daß die Oberflächenstrukturierung der Glasträgerplatte (3) schräg zu den Kanten (A-B, B-C, C-D, D-A) der Bearbeitungsebene (A-B-C-D) vorzunehmen ist.

14. Verfahren nach einem der Ansprüche 1 bis 4, d a - d u r c h   g e k e n n z e i c h n e t ,  daß elektrisch neutrale Teilchen für den Teilchenbeschuß vorgesehen sind.

15. Verfahren nach einem der Ansprüche 1 bis 4, d a - d u r c h   g e k e n n z e i c h n e t ,  daß Ionen für den Teilchenbeschuß vorgesehen sind.

16. Verfahren nach Anspruch 15, d a d u r c h   g e - k e n n z e i c h n e t ,  daß eine durch Teilchenbeschuß mittels Ionen auftretende elektrische Aufladung der bearbeiteten Glasträgerplatte (3) durch an sich bekannte Maßnahmen neutralisiert wird.

17. Verfahren nach einem der Ansprüche 1 bis 4, d a - d u r c h   g e k e n n z e i c h n e t ,  daß anstelle des Bedampfens ein Auftragen von Material mittels Sputtern vorgesehen ist.

0004900

78 P 7042

5    VPA

18. Verfahren nach einem der Ansprüche 1 bis 4, d a -
d u r c h  g e k e n n z e i c h n e t ,  daß anstelle
des Bedampfens ein Auftragen von Material mittels
selektiver chemischer Abscheidung vorgesehen ist.

FIG 1

FIG 2

FIG 3

FIG 4

FIG 5

FIG 6

## FIG 7

## FIG 8

## FIG 9

## FIG 10